(19) Europäisches Patentamt / European Patent Office / Office européen des brevets

(11) **EP 1 993 204 B1**

(12) **EUROPEAN PATENT SPECIFICATION**

(45) Date of publication and mention
of the grant of the patent:
**28.08.2013 Bulletin 2013/35**

(51) Int Cl.:
*H03G 3/30* *(2006.01)*     *H03G 3/20* *(2006.01)*

(21) Application number: **07290641.5**

(22) Date of filing: **15.05.2007**

(54) **Method of adjusting a gain of a radio frequency receiver**

Verfahren zur Anpassung der Leistung eines Funkfrequenzempfängers

Procédé de réglage de gain d'un récepteur à fréquence radio

(84) Designated Contracting States:
**AT BE BG CH CY CZ DE DK EE ES FI FR GB GR
HU IE IS IT LI LT LU LV MC MT NL PL PT RO SE
SI SK TR**

(43) Date of publication of application:
**19.11.2008 Bulletin 2008/47**

(73) Proprietor: **Alcatel Lucent
75007 Paris (FR)**

(72) Inventor: **Dismer, Mark
74343 Sachsenheim (DE)**

(74) Representative: **Wetzel, Emmanuelle et al
Alcatel-Lucent Deutschland AG
Intellectual Property & Standards
70430 Stuttgart (DE)**

(56) References cited:
**EP-A- 1 241 779     EP-A- 1 309 093
WO-A-02/21686     US-A1- 2003 186 665
US-A1- 2003 207 674**

**Description**

**Technical field**

The invention relates to a method of adjusting a gain of a radio frequency receiver, a radio frequency receiver, a base station, a method of providing a calibration table to a radio frequency receiver and a computer program product.

**Background and related art**

In mobile telecommunication systems, receivers play an important role. They can be for example implemented in base stations for receiving signals from mobile stations, or vice versa they can be implemented in mobile stations for receiving signals transmitted by base stations. Thereby, typically superheterodyne receiver architectures are the preferred kinds of receivers used in today's wireless communication systems. This architecture utilizes a down conversion process having separate intermediate frequencies (IF) which allows to simplify filters at each mixer stage. Heterodyne receivers mix all the incoming signals with an internally generated waveform called the local oscillator (LO). This allows to overcome certain limitations of previous receiver designs. While tuned radio frequency receivers suffer from poor selectivity, superheterodyne receivers have the advantage that most of the radio signal's path within the receiver has only to be sensitive to a narrow range of frequencies. Only one or two of the tuned stages need to be adjusted to track over the tuning range of the receiver. All the intermediate frequency stages operate at a fixed frequency which need not to be adjusted and can therefore be designed in an optimized way for a specific frequency range.
In order to further overcome obstacles such as image response, more than one IF is used. Receivers comprising two frequency converters are called double conversion superheterodyne receivers.
For example US 5,603,099 and US 4,661,995 disclose superheterodyne receivers. One of the major problems of wideband receivers is however the variation in gain across the RF frequency range. This reduces the amplification dynamics of said receivers which becomes an even more serious problem, if a large signal bandwidth comprising multiple channels has to be amplified, which requires an optimum amplification behavior of the receiver over the complete multi carrier bandwidth.
US 4,138,645 discloses a wideband signal calibration system. US 2006/0291549 A1 discloses an automatic receiver calibration with noise and fast fourier transform and WO 2004/071005 A1 discloses a method and apparatus for automatic gain control of a multi carrier signal in a communication receiver.
EP1241779 does disclose a receiver used in multi-carrier reception consisting of an analogue receiver part and a digital receiver part. The analogue receiver part comprises an automatic gain control and the digital receiver part comprises a digital gain block for adjusting a subcarrier power based on a power measured by means of a digital power measurement logic within the digital part.

Summary of the invention

The present invention provides a method of adjusting a gain of a radio frequency (RF) receiver, the receiver comprising an analogue chain, a digital chain and a database, wherein the database comprises a table, wherein the table comprises analogue gains and digital gains as a function of first and second RF frequencies, the method comprising receiving an RF signal, mixing the received RF signal with a first RF frequency for obtaining an RF signal at an intermediate frequency, selecting an analogue gain from the table using the first RF frequency, amplifying in said analogue chain the RF signal with the intermediate frequency using the selected analogue gain, analogue digital converting of the amplified RF signal, down converting the digitized RF signal using a second RF frequency, selecting a digital gain from said table using the first and the second RF frequency and adjusting the digitized signal in the digital chain using the selected digital gain.
The method according to the invention has the advantage, that a calibration of said receiver has only to be performed once for example during a factory calibration process. All necessary information for further operation of the receiver is contained in the database of the receiver which allows for optimum self-adjustment of the gain of the radio frequency receiver with respect to the RF frequency and the second RF frequency of for example a carrier comprised in said signal input to the receiver. The method smoothes the receivers gain over frequency uncertainties in dependency of the super heterodyning of the different RF frequency band widths.
In accordance with the invention, the receiver is a multi carrier receiver. For example, the digital gain is selected from the database on a carrier basis. In case of a pure analogue amplification stage, a received multi carrier signal can only be amplified with an amplification factor being the same for all carriers comprised in said signal. However, with the possibility that the digital gain is selected on a respective carrier basis, in the digital chain an individual amplification for each carrier can be performed using the digital gain selected for a respective specific carrier which allows to highly effectively use the receiving dynamics of the receiver.

In accordance with an embodiment of the invention, the receiver is a superheterodyne receiver. The received RF signal is converted to a fixed lower frequency using the first RF frequency, wherein the selection of the analogue gain from database is based on said first RF frequency and wherein the RF signal with the fixed lower frequency is amplified using the selected analogue gain. Adjusting the amplification gain by selecting the amplification gain from the database based on the first RF frequency allows for a highly flexible design of the receiver.

In another aspect, the invention relates to a radio frequency (RF) receiver comprising an analogue chain, a digital chain and a database, wherein the database comprises a table, wherein the table comprises analogue gains and digital gains as a function of first and second RF frequencies, the receiver comprising means for receiving an RF signal, a mixer for mixing the received RF signal with a first RF frequency for obtaining an RF signal at an intermediate frequency, means for selecting an analogue gain from the table using the first RF frequency, means for amplifying the RF signal with the intermediate frequency using the selected analogue gain in said analogue chain, means for analogue digital converting of the amplified RF signal, means for down converting the digitized RF signal using a second RF frequency, means for selecting a digital gain from the table using the first and the second RF frequency and means for adjusting the digitized signal in the digital chain using the selected digital gain.

In another aspect, the invention relates to a base station or a mobile station comprising a receiver according to the invention.

Further described is a method of providing a calibration table to a radio frequency (RF) receiver, the receiver comprising an analogue chain and a digital chain, the receiver further comprising means for receiving an RF signal with a first RF frequency, means for amplifying the RF signal using an analogue gain, means for analogue digital converting of the amplified RF signal, means for down converting a digitized RF signal using a second RF frequency and means for adjusting the digitized signal in a digital chain using a digital gain. The method comprises receiving an RF signal with a first RF frequency, amplifying said RF signal with the first RF frequency, determining the amplification response of the receiver with respect to the received RF signal with the first RF frequency depending on the analogue amplification gain, determining the amplification response of the receiver with respect to the down converted RF signal with the second RF frequency depending on the second RF frequency, determining the amplification response of the receiver with respect to the RF signal with first RF frequency depending on the first RF frequency, calculating analogue and/or digital gain correction values based on determined amplification responses with respect to the first and second RF frequencies and storing the calculated analogue and/or digital gain correction values in a database, the database being comprised in the receiver.

Using the calibration method has the advantage, that a calibration does only have once to be performed over the complete first and second RF frequency range in order to obtain an accurate calibration database to be used for analogue and/or digital gain correction of the receiver. It is sufficient to perform measurements for determining the amplification response of the receiver only for a limited number of analogue amplification gain values, second RF frequency values and first RF frequency values. By performing the calculation based on the determined amplification response of the receiver a matrix type table comprising analogue and/or digital gain correction values can be obtained which allows for a quick and accurate amplification adjustments of for example multi carrier receivers.

For example the analogue and/or digital gain correction values are calculated with respect to inband ripple and to the analogue and digital chain's dynamics. This allows for an individual adjustment of the analogue and digital amplification chains with respect to an input RF signal. The amplification dynamics of the receiver is thereby used in an optimum way for each combination of the RF frequencies.

In another aspect the invention relates to a computer program product comprising computer executable instructions to perform the method of adjusting gain of the radio frequency receiver according to the invention.

**Brief description of the drawings**

In the following preferred embodiments of the invention will be described in greater detail by way of example only making reference to the drawings in which:

Fig 1:     shows a block diagram of a superheterodyne receiver architecture,

Fig 2:     shows a block diagram for a test setup for calibrating a receiver according to the invention,

Fig 3:     shows a flowchart illustrating a method for calibrating a receiver according to the invention.

**Detailed description**

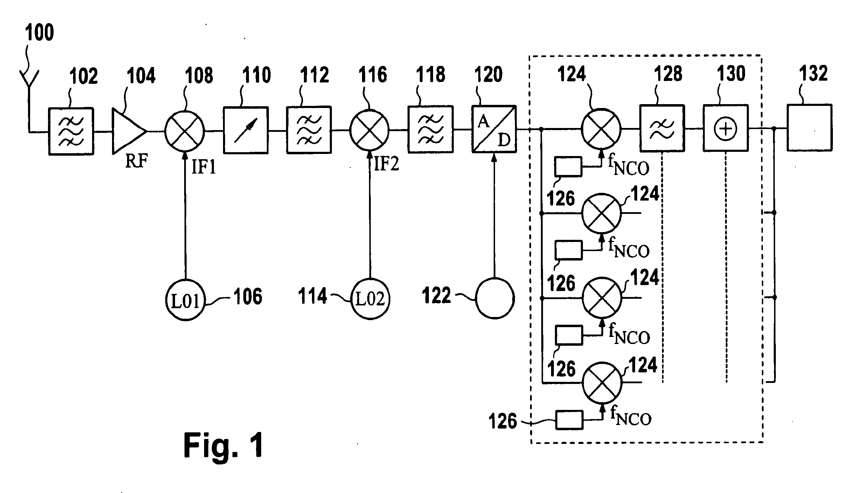

Fig. 1 shows a block diagram of a double conversion superheterodyne receiver architecture. The receiver comprises an antenna 100 and a band select filter 102. A first stage of amplification of the signal received by the antenna 100 is performed using a low noise amplifier (LNA) 104. The amplified signal is then input into a mixer 108, which uses a voltage control oscillator (VCO) 106 in order to down convert the received RF signal to a first fixed intermediate frequency (IF). Therefore, the signal mixed together with the received RF signal in the mixer 108 has a variable frequency (LO1).

After the signal has been down converted to the first intermediate frequency (IF1) the IF1 signal is input into a gain trimmable amplifier 110 (GTA). The GTA allows for digital controlled incremental gain steps. Depending on LO1, a respective GTA step is selected from a database, the database being comprised in the receiver. This allows for a highly efficient adjustment of the amplification factor in order to amplify the IF1 signal with respect to the amplification dynamics of the receiver.

After passing the GTA 110 the amplified IF1 signal is put into a filter 112, which allows for frequency rejection of out of band unwanted signals. After passing the filter 112, the IF1 signal is put into a second mixer 116 which is operated using a second voltage controlled oscillator (VCO) 114. Thereby, the mixer 116 is adapted to down convert the IF1 signal using a signal at fixed frequency (LO2) to a second signal with a second intermediate frequency IF2. After down conversion of the IF1 signal to the IF2 signal via the mixer 116, the IF2 signal is put into a second IF filter 118. After passing the second IF filter 118, the IF2 signal is put into an analogue digital converter 120 which itself is operated using a sample clock 122.

Now, the digitized signal is put into the digital receive chain. This digital receive chain comprises multiple mixers 124 with respective numeric controlled oscillators (NCO) 126. Each mixer-NCO (124, 126) unit can thereby be individually adjusted using the NCOs 126 to down convert the digitized signal. This has the advantage, that for the multi carrier receiver shown in fig. 1, an individual digital gain control using respective digital gain control units 130 can be performed on each carrier comprised in the digitized signal. Thereby, the digital gain control units 130 receive respective digital gain control correction values from the same database which was already used in order to control the gain trimmable amplifier 110.

After down converting the digitized signal using the mixer 124, the down converted digitized signal is passed through another filter 128 and the already mentioned digital gain control unit 130. Thereby, each mixer 124 is connected to a respective filter 128. For further processing the digitized respective signals are put into a digital signal processor 132.

It should be mentioned, that the mentioned database comprises for a multitude of LO1 frequencies respective GTA steps and absolute DGC correction values at respective NCO frequencies. As an example for such a table comprised in a database of the receiver refer to the below calibration procedure for multi carrier receivers, section 1.3.7.

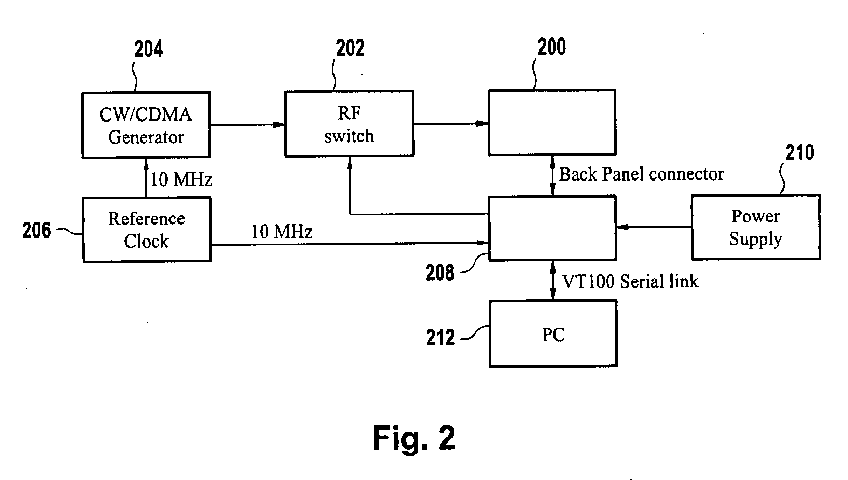

Fig. 2 shows a block diagram for a test setup for calibrating a receiver according to the invention. The receiver 200 is connected via an RF switch 202 to a signal generator 204. The signal generator 204 is controlled by a reference clock 206. The receiver 200 is further connected to a test unit 208, which is also connected to the reference clock 206 and which is further connected to the RF switch 202. The test unit 208 is additionally connected to a power supply 210.

In order to for example perform a response test of the receiver 200 with respect to the RF frequency input to the receiver 200, the gain trimmable amplifier (GTA) comprised in the receiver 200 is set to a fixed value, as well as the NCO frequency in the digital receiver chain of the receiver 200. An RF signal is generated by the signal generator 204, input to the receiver 200 and the response of the receiver in terms of signal amplification is measured by the test unit 208. The resulting measurement values are then input to the computer 212 and stored in a respective table as for example shown under 1.3.5.3 of the below calibration procedure for multicarrier receivers (RF Frequency Response Test section).

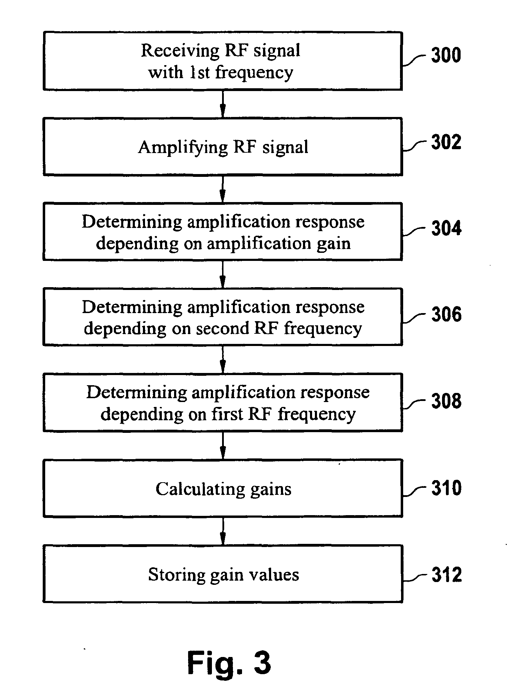

Fig. 3 shows a flowchart illustrating a method for calibrating a receiver according to the invention. In step 300 an RF signal with a first RF frequency is received. The received RF signal is amplified in step 302 which allows for setting the GTA to work in its optimal dynamic range. Regarding a detailed description of the test of the GTA refer to 1.3.2 of the below calibration procedure protocol for multi carrier receivers.

In steps 304 to 308, the amplification response of the receiver is tested depending on various parameters. For example, in step 304 the amplification response of the receiver is determined depending on the amplification gain. This means, that only the amplification gain is varied, whereas the RF frequency and the DGC gain is set constant. This is described in detail under 1.3.2 of the below calibration procedure for multicarrier receivers.

In step 306, the amplification response of the receiver is determined depending on the second RF frequency. Here, the term second RF frequency refers to the NCO frequency for a carrier in the digital receive chain. In order to perform step 306, the first RF frequency, as well as the amplification gain of the analogue receive chain is kept constant. The procedure of step 306 is described in detail under 1.3.3 (IF frequency response test) of the below calibration procedure for multi carrier receivers protocol.

In step 308, the amplification response of the receiver is determined depending on the first RF frequency. In this case, the amplification gain as well as the second RF frequency (NCO frequency) is held constant, while the first RF frequency, preferably LO1 is varied. A detailed description of the RF frequency response test is disclosed under 1.3.4 of the below calibration procedure protocol.

In step 310, the resulting tables from the steps 304 to 308 are analyzed. Gain correction values depending on the LO1 frequency and the NCO frequency are calculated as described under 1.3.5 (RF frequency response calibration) of the below calibration procedure protocol.

Finally, in step 312 the calculated gain values are stored for example into a memory of the receiver.

In the following, an exemplary calibration procedure for multi carrier receivers is described in a more detailed way:

## Calibration procedure for multi carrier receivers

1.1 Frequency allocation

Frequency definition:

| | | |
|---|---|---|
| $f_{RFmid}$: | 1947.6 MHz | middle channel RF frequency |
| $f_{LO1mid}$: | 1593.0 MHz | middle LO1 synthesizer frequency |
| $f_{LO2}$: | 299.4 MHz | fixed LO2 synthesizer frequency |
| $f_{IF1mid}$: | 357.1 MHz | middle first IF frequency |
| $f_{IF2mid}$: | 57.7 MHz | middle second IF frequency |
| $f_{SAMPLE}$: | 76.8 MHz | ADC sample frequency |
| $f_{NCOmid}$: | 19.1 MHz | middle NCO frequency |
| $f_{OFFSET}$: | 2.5 MHz | offset frequency (half channel spacing) |

1.2 General Initialisation

The following settings are necessary to enable the first test step of the receiver(s).

a) Switch on the power supply
b) Program SG to CDMA single code signal of: $f_{RFmid}$ = 1947.604 MHz

Signal power to (without front end): $p_{RF}$ = -39.5 dBm
Signal power to: $p_{RF}$ = -75.5 dBm

c) Set LNA 0 attenuation to 0 dB
d) Set GTA 0 attenuation to 0 dB
e) Program receiver LO1 synthesizer to:

$$f_{LO1mid} = f_{RFmid} - f_{IF1mid} + f_{OFFSET} = 1947.6 \text{ MHz} - 357.1 \text{ MHz} + 2.5 \text{ MHz} = 1593.0 \text{ MHz}$$

f) Program the NCO01 to:

$$f_{NCO01} = f_{LO2} + f_{SAMPLE} - f_{IF1} = 299.4 \text{ MHz} + 76.8 \text{ MHz} - 354.6 \text{ MHz} = 21.6 \text{ MHz}$$

g) Set DGC01 correction value to a default value.

Remark: A CDMA single code signal is a UMTS signal with one UE 12.2 kbps uplink channel.

1.3 Test and Calibration Description

1.3.1 Initial Receiver Test

1.3.1.1 Principle

A CDMA single code signal is supplied to the RX 0 antenna input of the receiver. The PC reads the DGC data at DDC01 coming from ADC 0 and compares it to the test limits.

To measure the purity and the accuracy of the synthesizers, it is necessary to get the I - and Q samples after the DDC (within the FPGA), calculate the frequency offset and the phase error on the PC and compare the result to the test limits.

### 1.3.1.2 Test steps

a) Settings as described on initialisation a) to g).
b) Read board temperature
c) Read DGC value at DDC01
d) Write result to memory
e) Program SG to: CW signal (1947.6 MHz, without offset))
f) Get 4096 I- and Q samples at DDC (DGC output, 8 bit interface to QUICC)
g) Calculate the peak - and rms phase error and the frequency offset
h) Write result to memory
i) compare result to test limits

### 1.3.2 Test of the GTA

#### 1.3.2.1 Principle

A CDMA single code signal is supplied to the RX 0 antenna input of the receiver. The QUICC set defined GTA 0 steps, read the DGC data's at DDC01 coming from ADC 0 and compares it to the test limits.

If the GTA test is successful completed, the GTA is working in its used gain correction range. Further tests can be done. If not, the test has to be stopped and an error has to be reported.

#### 1.3.2.2 Test steps

a) Settings as described on initialisation.
b) Read board temperature and write it to result file
c) In dependence on the initial receiver test result calculate the necessary GTA step for DGC = 5368

$$\text{GTAstep} = \text{INTEGER} \left( 2 * 20 * \log_{10} (\text{initial DGC value} / 5368) \right)$$

d) Set the calculated GTA step
e) Read DGC value at DDC01
f) If the DGC value is less than the min. first GTA step, then decrease GTA step by 1
g) Repeat d) to f) until the DGC value is whithin the first GTA step limits
h) If the DGC value is higher than the max. first GTA step, then increase GTA step by 1
i) Repeat d), e) and h) until the DGC value is within the first GTA step limits
j) Read DGC value at DDC01: GTAsteppower
k) Calculate ADC power: $p_{ADC}$ [dBFS] = 20 * LOG (DGC) - 146.6 + 35
l) Calculate step size: GTAstepsize [dB] = 20 * LOG (DGCnew / DGCold) The step size is the difference between the actual DGC value and the previous DGC value (except first DGC value)
m) If the GTAstepsize is higher than -0.1 dB (0.989), (but within the test limits), then ignore the actual GTA step (for this and all further calibration steps - take the previous GTA step as reference for the next GTA step)
n) Write result to memory
o) Increase GTA step by 1
p) Repeat j) to o) until measured DGC power is less than 2690
q) Create GTA step table which shows the results (GTAstep, GTAsteppower, $p_{ADC}$ and GTAstepsize), see example

1.3.2.3 Example for result file

GTA test

Temp: 27 °C

Table for result file:

| No. | absolute GTAstep | GTAsteppower (DGC value) | $p_{ADC}$ / dBFS | GTAstepsize / dB |
|---|---|---|---|---|
| 1 | 12 | 5700 | -36,48 | --- |
| 2 | 13 | 5300 | -37,11 | -0.63 |
| 3 | 14 | 5000 | -37,62 | -0.51 |
| 4 | 15 | 4500 | -38,54 | -0.92 |
| 5 | 16 | 4300 | -38,93 | -0.39 |
| 6 | 17 | 3900 | -39,78 | -0.85 |
| 7 | 18 | 3700 | -40,24 | -0.46 |
| 8 | 19 | 3500 | -40,72 | -0.48 |
| 9 | 20 | 3300 | -41,23 | -0.51 |
| 10 | 21 | 3200 | -41,50 | -0.27 |
| 11 | 22 | 3000 | -42,06 | -0.56 |
| 12 | 23 | 2900 | -42,35 | -0.29 |
| 13 | 24 | 2700 | -42,97 | -0.62 |
| 14 | 25 | 2600 | -43,30 | -0.33 |
| | | | | |
| Result: OK<br>Remark: GTAref. = 18 (the next value which is equal or less than DGC = 3800), is need for next test step. | | | | |

1.3.3 IF Frequency Response Test

1.3.3.1 Principle

A CDMA single code signal is supplied to the RX 0 antenna input of the receiver. The QUICC sets four LO1 frequencies and the corresponding NCO frequencies, read the DGC data's at DDC00 to DDC03 coming from ADC 0 and compares them to the test limits.

If the IF frequency response test is successful completed, the measurement results can be used for digital gain correction. Further tests can be done. If not, the test has to be stopped and an error has to be reported.

1.3.3.2 Test steps

a) Settings as described on initialisation.
b) Read board temperature and write to memory
c) Set GTA 0 as close as possible to DGC = 3800 from measurement results found at GTA test
d) Write GTA step to memory: GTAref.
e) Read DGC value at DDC01 and write result to memory
f) Set all DGC correction values to default: DGCdef. = 32768
g) Program receiver LO1 synthesizer to:

$$f_{LO1} = f_{RFmid} - f_{IF1mid} + 3 * f_{OFFSET} = 1947.6 \text{ MHz} - 357.1 \text{ MHz} + 7.5 \text{ MHz} = 1598.0 \text{ MHz}$$

Now $f_{IF1}$ is 349.6 MHz and $f_{IF2}$ is 50.2 MHz.

h) Program the NCOOO to: $f_{NCO00} = f_{LO2} + f_{SAMPLE} - f_{IF1} = 26.6$ MHz

i) Read DGC value at DDC00 and write result to memory

j) Program receiver LO1 synthesizer to:

$$f_{LO1} = f_{RFmid} - f_{IF1mid} - 1 * f_{OFFSET} = 1947.6 \text{ MHz} - 357.1 \text{ MHz} - 2.5 \text{ MHz} = 1588.0 \text{ MHz}$$

k) Program the NCO02 to: $f_{NCO02} = f_{LO2} + f_{SAMPLE} - f_{IF1} = 16.6$ MHz

l) Read DGC value at DDC02 and write result to memory

m) Program receiver LO1 synthesizer to:

$$f_{LO1} = f_{RFmid} - f_{IF1mid} - 3 * f_{OFFSET} = 1947.6 \text{ MHz} - 357.1 \text{ MHz} - 7.5 \text{ MHz} = 1583.0 \text{ MHz}$$

n) Program the NCO03 to: $f_{NCO03} = f_{LO2} + f_{SAMPLE} - f_{IF1} = 11.6$ MHz

o) Read DGC value at DDC03 and write result to memory

p) Calculate IF frequency response: $IF_{resp.} = DGC_{max.} / DGC_{min.}$ ($IF_{resp.}$ [dB] = 20 * LOG ($IF_{resp.}$))

$$IF_{resp.} = DGC_{max.} / DGC_{min.} \qquad (IF_{resp.} \text{ [dB]} = 20 * LOG (IF_{resp.}))$$

q) Write results into the result file, see example

1.3.3.3 Example for result file

IF frequency response test

Temp: 28 °C

GTAref. = 18 (result from GTA test table)

Result at $f_{RFmid}$:

| IF | $f_{NCO}$/MHz | $DGC_{IF}$ |
|---|---|---|
| 0 | 26.6 | 3500 |
| 1 | 21.6 | 3700 |
| 2 | 16.6 | 3800 |
| 3 | 11.6 | 3900 |
| IFresp. : 0.94 dB (1.114) Result: OK Limit: 1.3 (2.28 dB) | | |

1.3.4 RF Frequency Response Test

1.3.4.1 Principle

A CDMA single code signal is supplied to the RX 0 antenna input of the receiver. For this test a constant IF center frequency signal is needed.

The QUICC sets 12 LO1 frequencies and the corresponding RF frequencies to the SG so, that the IF channel remains constant. The QUICC read the DGC data's at DDC01 coming from ADC 0 and compares them to the test limits.

If the RF frequency response test is successful completed, the measurement results can be used for analogue (GTA) and digital gain correction. Further tests can be done. If not, the test has to be stopped and an error has to be reported.

1.3.4.2 Test steps

a) Settings as described on initialisation.
b) Read board temperature
c) Set GTA 0 as close as possible to DGC = 3800 from measurement results found at GTA test
d) Write GTA step to memory: GTAref.
e) Read DGC value at DDC01
f) Write result to memory
g) Program SG to: $f_{RF}$ = 1922.6 MHz (+ 4 kHz offset)
h) Program receiver LO1 synthesizer to:

$$f_{LO1} = f_{RF} - f_{IF1mid} + f_{OFFSET} = 1922.6 \text{ MHz} - 357.1 \text{ MHz} + 2.5 \text{ MHz} = 1568.0 \text{ MHz}$$

i) Read DGC value at DDC01
j) Write result to memory
k) Increase $f_{RF}$ by 5.0 MHz
l) Increase $f_{LO1}$ by 5.0 MHz
m) Read DGC value at DDC01
n) Write result to memory
o) Repeat k) to n) until $f_{RF}$ = 1977.6 MHz and $f_{LO1}$ = 1623.0 MHz
p) Calculate RF frequency response:

$$RF_{resp.} = DGC_{max.} / DGC_{min.} \quad (RF_{resp.} \text{ [dB]} = 20 * LOG (RF_{resp.}))$$

q) Write results into the result file, see example

1.3.4.3 Example for result file

RF frequency response test
Temp: 28 °C
GTAref. = 18 (result from GTA test table)
Result at $f_{IFmid}$:

| RF | $f_{RF}$ / MHz | $DGC_{RF}$ |
|----|------|------|
| 0 | 1922.6 | 3600 |
| 1 | 1927.6 | 3500 |
| 2 | 1932.6 | 3450 |
| 3 | 1937.6 | 3550 |
| 4 | 1942.6 | 3650 |
| 5 | 1947.6 | 3700 |
| 6 | 1952.6 | 3800 |

(continued)

| RF | $f_{RF}$ / MHz | $DGC_{RF}$ |
|---|---|---|
| 7 | 1957.6 | 3850 |
| 8 | 1962.6 | 3950 |
| 9 | 1967.6 | 4000 |
| 10 | 1972.6 | 4150 |
| 11 | 1977.6 | 4350 |

$RF_{resp.}$ : 2.01 dB (1.261)
Result: OK
Limit: 1.5 (3.52 dB)

1.3.5 RF Frequency Response Calibration

1.3.5.1 Principle

This is the creation of the RF correction table. Herewith the analogue pre correction of the RF frequency response is done by programming the GTA. In dependence of the RF-LO synthesizer frequency a GTA step is stored into the memory.

If later the chosen $f_{LO1}$ is between two table values, the nearest value has to be used for GTA programming (tbd.).

1.3.5.2 Calculation steps

a) Prepare table for $f_{LO1(0)}$ = 1558 MHz to $f_{LO1(14)}$ = 1628 MHz in steps of 5.0 MHz start with $f_{LO1(0)}$ = 1558 MHz ( m = 0, ..., 14)

b) Calculate the power for the corresponding four IF channels of $f_{LO1(m)}$ as follows:

$$DGC(m, n) = DGC[f_{RF}] * \Delta DGC_{IF(n)}$$

$$DGC(m, n) = DGC[f_{LO1(m)} + f_{IF1(n)}] * DGC_{IF(n)} / DGC_{IF(1)} \qquad n = 0, ..., 3$$

$DGC_{IF(n)}$ , $DGC_{IF(1)}$ : values found in IF frequency response test

Remark: $\Delta DGC_{IF(1)}$ = 1, because it is the reference

$DGC[f_{RF}]$ is the DGC measurement result from the RF frequency response test at the calculated frequency $f_{RF}$ (= $f_{LO1(m)} + f_{IF1(n)}$)

If $f_{RF}$ = $[f_{LO1(m)} + f_{IF1(n)}]$ < 1920 MHz or > 1980 MHz, then ignore value

c) Search the maximum of the calculated power values: DGC[max.]

d) Calculate the power for the GTA step:

$$DGC_{cal.}[GTAstep] = DGC[GTAref.] / DGC[max.] * 3800$$

DGC[GTAref.] is the measured power (GTAsteppower) from the GTAref. step to be find in "test of the GTA" table

e) Choose the power for the GTA step to set from GTA table created in test step q) of GTA test: GTAsteppower

Remark: use the lower power value, if result is between two steps into the table

f) Look into the GTA table (Test of the GTA) for GTAstep to set

g) Create RF correction table: ($f_{LO1}$ and GTAstep), (15 lines)

h) Store found GTAstep into the RF correction table

i) Repeat b) to h) until $f_{LO1}$ = 1628 MHz

j) Write to result file: see example

k) Write $f_{LO1}$ with the accompanying GTAstep to memory
l) Read back the written data from memory and compare it to the programming data (programming verify)

1.3.5.3 Example for result file

RF frequency response calibration

| $f_{LO1}$ / MHz | DGC$_{cal.}$[GTAstep] | absolute GTAstep |
|---|---|---|
| 1558 | 3705 | 18 |
| 1563 | 3803 | 18 |
| 1568 | 3866 | 18 |
| 1573 | 3757 | 18 |
| 1578 | 3655 | 19 |
| 1583 | 3605 | 19 |
| 1588 | 3510 | 19 |
| 1593 | 3465 | 20 |
| 1598 | 3377 | 20 |
| 1603 | 3335 | 20 |
| 1608 | 3214 | 21 |
| 1613 | 3066 | 22 |
| 1618 | 3147 | 22 |
| 1623 | 3232 | 21 |
| 1628 | 3417 | 20 |
| GTAstep difference: 4<br>Result: OK<br>Limit: 8 | | |

1.3.6 IF Frequency Response Calibration

1.3.6.1 Principle

This is the creation of the IF correction table. Herewith the digital gain correction (DGC) of the RF - and IF frequency response is done by adjusting the DGC correction registers within the FPGA. In dependence of the LO1 synthesizer frequency, maximum four DGC correction values are stored into the memory.

1.3.6.2 Calculation steps

a) Prepare table for $f_{LO1(0)}$ = 1558 MHz to $f_{LO1(14)}$ = 1628 MHz in steps of 5.0 MHz start with $f_{LO1(0)}$ = 1558 MHz
b) Create IF correction table: ($f_{LO1}$ and DGCnew), (15 lines)
c) Calculate the DGC correction values for the corresponding four IF channels of $f_{LO1}$ as follows:

$$\Delta DGC_{(m, n)} = DGC[GTAref.] / GTAsteppower * DGC_{IF(1)} / DGC_{IF(n)} * 3800 / DGC[f_{LO1(m)} + f_{IF1(n)}]$$

DGCnew = DGCdef. * $\Delta DGC_{(m, n)}$ m = 0, ..., 14 n = 0, ..., 3

DGC[GTAref.] is the measured power (GTAsteppower) from the GTAref. step to be find in "test of the GTA" table. GTAsteppower is the power for the GTA step to set from GTA table created in test step q) of GTA test (GTAstep from $f_{LO1}$ of table from RF frequency response calibration)

$\Delta DGC_{IF(n)} = DGC_{IF(n)} / DGC_{IF(1)}$ from values found in IF frequency response test $DGC[f_{LO1(m)} + f_{IF1(n)}] = DGC[f_{RF}]$ is the DGC measurement result from the RF frequency response test at the calculated frequency $f_{RF}$

If $f_{RF} = [f_{LO1(m)} + f_{IF1(n)}]$ < 1920 MHz or > 1980 MHz, then ignore value

d) Store found new DGC correction values into the IF correction table

e) Repeat c) and d) until $t_{LO1}$ = 1628 MHz

f) Write to result file: DGCnew values with the accompanying $f_{LO1}$ and $f_{NCO}$ frequencies

1.3.6.3 Example for result file

IF frequency response calibration

Values to be stored into memory:

| $f_{LO1}$ / MHz | absolute DGC correction values (DGCnew) at $f_{NCO}$ / MHz | | | |
|---|---|---|---|---|
| | 26.6 | 21.6 | 16.6 | 11.6 |
| 1558 | --- | --- | --- | 32815 |
| 1563 | --- | --- | 33678 | 33752 |
| 1568 | --- | 34588 | 34640 | 34241 |
| 1573 | 36565 | 35577 | 35142 | 33277 |
| 1578 | 39759 | 38155 | 36104 | 34215 |
| 1583 | 40335 | 37080 | 35115 | 33752 |
| 1588 | 39199 | 36064 | 34640 | 32864 |
| 1593 | 40435 | 37733 | 35773 | 34403 |
| 1598 | 39889 | 36740 | 35308 | 33532 |
| 1603 | 38839 | 36263 | 34415 | 33113 |
| 1608 | 39533 | 36449 | 35046 | 32914 |
| 1613 | 41101 | 38393 | 36032 | 33494 |
| 1618 | 40587 | 37005 | 34375 | --- |
| 1623 | 36675 | 33098 | --- | --- |
| 1628 | 33929 | --- | --- | --- |
| DGC$_{min.}$: 32815 DGC$_{max.}$: 41101 | | | | |

1.3.6.4 Table to be stored into the Memory

Example:

| $f_{LO1}$ / MHz | absolute GTAstep | absolute DGC correction values at $f_{NCO}$ / MHz | | | |
|---|---|---|---|---|---|
| | | 26.6 | 21.6 | 16.6 | 11.6 |
| 1558 | 18 | --- | --- | --- | 32815 |
| 1563 | 18 | --- | --- | 33678 | 33752 |
| 1568 | 18 | --- | 34588 | 34640 | 34241 |

(continued)

| $f_{LO1}$ / MHz | absolute GTAstep | absolute DGC correction values at $f_{NCO}$ / MHz | | | |
|---|---|---|---|---|---|
| 1573 | 18 | 36565 | 35577 | 35142 | 33277 |
| 1578 | 19 | 39759 | 38155 | 36104 | 34215 |
| 1583 | 19 | 40335 | 37080 | 35115 | 33752 |
| 1588 | 19 | 39199 | 36064 | 34640 | 32864 |
| 1593 | 20 | 40435 | 37733 | 35773 | 34403 |
| 1598 | 20 | 39889 | 36740 | 35308 | 33532 |
| 1603 | 20 | 38839 | 36263 | 34415 | 33113 |
| 1608 | 21 | 39533 | 36449 | 35046 | 32914 |
| 1613 | 22 | 41101 | 38393 | 36032 | 33494 |
| 1618 | 22 | 40587 | 37005 | 34375 | --- |
| 1623 | 21 | 36675 | 33098 | --- | --- |
| 1628 | 20 | 33929 | --- | --- | --- |

Read back the written data from memory and compare it to the programming data (programming verify).

2. GLOSSARY

| | |
|---|---|
| 3GPP | 3rd Generation Partnership Program |
| ADC | Analogue to Digital Converter |
| AGC | Automatic Gain Control |
| CDMA | Code Division Multiple Access |
| CW | Continuous Wave |
| dBFS | dB referred to full scale |
| DDC | Digital Down Converter |
| DGC | Digital Gain Control |
| FFT | Fast Fourier Transformation |
| FPGA | Field Programmable Gate Array |
| FT | Functional Test |
| GTA | Gain Trimmable Amplifier (GTAstep: 0 is max. gain, GTAstep: 32 is -16 dB nominal) |
| IF | Intermediate Frequency |
| LNA | Low Noise Amplifier |
| LO | Local Oscillator |
| NCO | numeric controlled oscillator |
| NF | noise figure |
| NodeB | Base Transceiver Station for UMTS |
| RF | Radio Frequency |
| RX | Receiver |
| SG | Signal Generator |
| UE | User Equipment (mobile station for UMTS) |
| UMTS | Universal Mobile Telecommunication System |
| VSWR | Voltage Standing Wave Ratio |
| W-CDMA | Wide band Code Division Multiple Access |

**List of Reference Numerals**

| 100 | Antenna |
|---|---|
| 102 | Band select filer |
| 104 | LNA |
| 106 | VCO |
| 108 | Mixer |
| 110 | Gain trimmable amplifier |
| 112 | Filter |
| 114 | VCO |
| 116 | Mixer |
| 118 | Filter |
| 120 | ADC |
| 122 | Sample clock |
| 124 | Mixer |
| 126 | NCO |
| 128 | Filter |
| 130 | Digital gain control |
| 132 | Digital signal processor |
| 200 | Receiver |
| 202 | RF switch |
| 204 | Signal generator |
| 206 | Reference clock |
| 208 | Test unit |
| 210 | Power supply |
| 212 | Computer |

**Claims**

1. A method of adjusting a gain of a multi-carrier radio frequency (RF) receiver, the receiver comprising an analogue chain, a digital chain and a database, wherein the database comprises a table, wherein the table comprises analogue gains and digital gains as a function of first and second RF frequencies, the method comprising:

   - receiving an RF signal,
   - mixing the received RF signal with a first RF frequency (LO1) for obtaining an RF signal at an intermediate frequency (IF1),
   - selecting an analogue gain from the table using the first RF frequency (LO1),
   - amplifying in said analogue chain the RF signal with the intermediate frequency (IF1) using the selected analogue gain,
   - analogue-digital converting of the amplified RF signal,
   - down-converting the digitized RF signal using a second RF frequency ($f_{NCO}$),
   - selecting a digital gain from said table using the first (LO1) and the second RF frequency ($f_{NCO}$),
   - adjusting the digitized signal in the digital chain using the selected digital gain.

2. The method of claim 1, wherein the receiver is a superheterodyne receiver.

3. A multi-carrier radio frequency (RF) receiver comprising an analogue chain, a digital chain and a database, wherein the database comprises a table, wherein the table comprises analogue gains and digital gains as a function of first and second RF frequencies, the receiver comprising:

- means (100) for receiving an RF signal,
- a mixer (108) for mixing the received RF signal with a first RF frequency (LO1) for obtaining an RF signal at an intermediate frequency (IF1),
- means for selecting an analogue gain from the table using the first RF frequency (LO1),
- means (110; GTA) for amplifying the RF signal with the intermediate frequency (IF1) using the selected analogue gain in said analogue chain,
- means (120) for analogue-digital converting of the amplified RF signal,
- means (124; 126) for down-converting the digitized RF signal using a second RF frequency ($f_{NCO}$),
- means for selecting a digital gain from the table using the first (LO1) and the second RF frequency ($f_{NCO}$),
- means (130) for adjusting the digitized signal in the digital chain using the selected digital gain.

**4.** A base station or a mobile station comprising a receiver according to claim 3.

**5.** A computer program product comprising computer executable instructions adapted to perform the method as claimed in any of the previous claims.

**Patentansprüche**

**1.** Verfahren zur Anpassung einer Verstärkung eines Mehrträger-Funkfrequenz-(RF)-Empfängers, wobei der Empfänger eine analoge Kette, eine digitale Kette und eine Datenbank umfasst, wobei die Datenbank eine Tabelle umfasst, wobei die Tabelle analoge Verstärkungen und digitale Verstärkungen in Abhängigkeit von ersten und zweiten RF-Frequenzen umfasst, wobei das Verfahren umfasst:

- Empfangen eines RF-Signals,
- Mischen des empfangenen RF-Signals mit einer ersten RF-Frequenz (LO1), um ein RF-Signal mit einer Zwischenfrequenz (IF1) zu erhalten,
- Auswählen einer analogen Verstärkung aus der Tabelle unter Verwendung der ersten RF-Zwischenfrequenz (LO1),
- Verstärken, in der besagten analogen Kette, des RF-Signals mit der Zwischenfrequenz (IF1) unter Verwendung der ausgewählten analogen Verstärkung,
- analog-digital-Umwandlung des verstärkten RF-Signals,
- Abwärtskonvertierung des digitalisierten RF-Signals unter Verwendung einer zweiten RF-Frequenz ($f_{NCO}$),
- Auswählen einer digitalen Verstärkung aus der besagten Tabelle unter Verwendung der ersten (LO1) und der zweiten RF-Frequenz ($f_{NCO}$),
- Anpassen des digitalisierten Signals in der digitalen Kette unter Verwendung des ausgewählten digitalen Signals.

**2.** Verfahren nach Anspruch 1, wobei der Empfänger ein Superheterodyn-Empfänger ist.

**3.** Mehrträger-Funkfrequenz-(RF)-Empfänger, umfassend analoge Kette, eine digitale Kette und eine Datenbank, wobei die Datenbank eine Tabelle umfasst, wobei die Tabelle analoge Verstärkungen und digitale Verstärkungen in Abhängigkeit von ersten und zweiten RF-Frequenzen umfasst, wobei der Empfänger umfasst:

- Mittel (100) zum Empfangen eines RF-Signals,
- einen Mischer (108) zum Mischen des empfangenen RF-Signals mit einer ersten RF-Frequenz (LO1), um ein RF-Signal mit einer Zwischenfrequenz (IF1) zu erhalten,
- Mittel zum Auswählen einer analogen Verstärkung aus der Tabelle unter Verwendung der ersten RF-Zwischenfrequenz (LO1),
- Mittel (110; GTA) zum Verstärken des RF-Signals mit der Zwischenfrequenz (IF1) unter Verwendung der ausgewählten analogen Verstärkung in der besagten analogen Kette,
- Mittel (120) zur analog-digital-Konvertierung des verstärkten RF-Signals,
- Mittel (124; 126) zur Abwärtskonvertierung des digitalisierten RF-Signals unter Verwendung einer zweiten RF-Frequenz ($f_{NCO}$),
- Mittel zum Auswählen einer digitalen Verstärkung aus der besagten Tabelle unter Verwendung der ersten (LO1) und der zweiten RF-Frequenz ($f_{NCO}$),
- Mittel (130) zum Anpassen des digitalisierten Signals in der digitalen Kette unter Verwendung des ausgewählten digitalen Signals.

**4.** Basisstation oder mobile Station, welche einen Empfänger gemäß Anspruch 3 umfasst.

**5.** Computerprogramm-Produkt mit computerausführbaren Befehlen, welche geeignet sind, das Verfahren gemäß einem beliebigen der vorstehenden Ansprüche durchzuführen.

**Revendications**

**1.** Procédé de réglage d'un gain d'un récepteur de radiofréquence (RF) multiporteuse, le récepteur comprenant une chaîne analogique, une chaîne numérique et une base de données, la base de données comprenant une table, la table comprenant des gains analogiques et des gains numériques en fonction d'une première et d'une deuxième fréquences RF, le procédé comprenant les étapes suivantes :

- réception d'un signal RF,
- mélange du signal RF reçu avec une première fréquence RF (LO1) pour obtenir un signal RF à une fréquence intermédiaire (IF1),
- sélection d'un gain analogique dans la table en utilisant la première fréquence RF (LO1),
- amplification dans ladite chaîne analogique du signal RF avec la fréquence intermédiaire (IF1) en utilisant le gain analogique sélectionné,
- conversion analogique-numérique du signal RF amplifié,
- conversion descendante du signal RF numérisé en utilisant une deuxième fréquence RF ($f_{NCO}$),
- sélection d'un gain numérique dans ladite table en utilisant la première (LO1) et la deuxième fréquences RF ($f_{NCO}$),
- réglage du signal numérisé dans la chaîne numérique en utilisant le gain numérique sélectionné.

**2.** Procédé selon la revendication 1, dans lequel le récepteur est un récepteur superhétérodyne.

**3.** Récepteur de radiofréquence (RF) multiporteuse comprenant une chaîne analogique, une chaîne numérique et une base de données, la base de données comprenant une table, la table comprenant des gains analogiques et des gains numériques en fonction d'une première et d'une deuxième fréquences RF, le récepteur comprenant :

- des moyens (100) pour recevoir un signal RF,
- un mélangeur (108) pour mélanger le signal RF reçu avec une première fréquence RF (LO1) pour obtenir un signal RF à une fréquence intermédiaire (IF1),
- des moyens pour sélectionner un gain analogique dans la table en utilisant la première fréquence RF (LO1),
- des moyens (110 ; GTA) pour amplifier le signal RF avec la fréquence intermédiaire (IF1) en utilisant le gain analogique sélectionné dans ladite chaîne analogique,
- des moyens (120) pour la conversion analogique-numérique du signal RF amplifié,
- des moyens (124 ; 126) pour la conversion descendante du signal RF numérisé en utilisant une deuxième fréquence RF ($f_{NCO}$),
- des moyens pour sélectionner un gain numérique dans la table en utilisant la première fréquence RF (LO1) et la deuxième fréquence RF ($f_{NCO}$),
- des moyens (130) pour régler le signal numérisé dans la chaîne numérique en utilisant le gain numérique sélectionné.

**4.** Station de base ou une station mobile comprenant un récepteur selon la revendication 3

**5.** Produit de programme informatique comprenant des instructions exécutables par ordinateur adaptées pour exécuter le procédé selon l'une quelconque des revendications précédentes.

**Fig. 1**

EP 1 993 204 B1

**Fig. 2**

Power Supply — 210

Back Panel connector

VT100 Serial link

200

PC — 212

208

RF switch — 202

10 MHz

CW/CDMA Generator — 204

10 MHz

Reference Clock — 206

```
┌─────────────────────────────────┐
│        Receiving RF signal       │──  300
│         with 1st frequency       │
└─────────────────────────────────┘
                 │
                 ▼
┌─────────────────────────────────┐
│        Amplifying RF signal      │──  302
└─────────────────────────────────┘
                 │
                 ▼
┌─────────────────────────────────┐
│   Determining amplification      │──  304
│   response depending on          │
│   amplification gain             │
└─────────────────────────────────┘
                 │
                 ▼
┌─────────────────────────────────┐
│   Determining amplification      │──  306
│   response depending on          │
│   second RF frequency            │
└─────────────────────────────────┘
                 │
                 ▼
┌─────────────────────────────────┐
│   Determining amplification      │──  308
│   response depending on          │
│   first RF frequency             │
└─────────────────────────────────┘
                 │
                 ▼
┌─────────────────────────────────┐
│        Calculating gains         │──  310
└─────────────────────────────────┘
                 │
                 ▼
┌─────────────────────────────────┐
│        Storing gain values       │──  312
└─────────────────────────────────┘
```

# Fig. 3

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5603099 A
- US 4661995 A
- US 4138645 A
- US 20060291549 A1
- WO 2004071005 A1
- EP 1241779 A